# EUROPEAN PATENT APPLICATION

(11) **EP 2 175 319 A1**
(43) Date of publication of application: **14.04.2010**
(21) Application number: 08791401.6
(22) Date of filing: 22.07.2008
(51) Int. Cl.: G03F 7/023, G03F 7/004, G03F 7/16, H01L 21/027

(54) **POSITIVE PHOTOSENSITIVE RESIN COMPOSITION FOR SPRAY COATING, METHOD FOR FORMING CURED FILM USING THE SAME, CURED FILM AND SEMICONDUCTOR DEVICE**

(30) Priority: 26.07.2007 JP 2007193973; 30.04.2008 JP 2008118233
(71) Applicant: Sumitomo Bakelite Company Limited, Shinagawa-ku Tokyo 140-0002 (JP)
(72) Inventor: BANBA, Toshio, Tokyo 140-0002 (JP); ORIHARA, Hideki, Tokyo 140-0002 (JP)
(74) Representative: Solf, Alexander
(86) International application number: PCT/JP2008/063120
(87) International publication number: WO 2009/014113

(57) **Abstract**

A positive photosensitive resin composition for spray coating of the present invention is used for forming a coating film onto a substrate such as a semiconductor element mounting substrate, a ceramics substrate or an aluminium substrate by spray coating. The positive photosensitive resin composition is **characterized by** containing (A) an alkali soluble resin, (B) a compound which generates an acid by the action of light and (C) a solvent, and having a viscosity of 2 to 200 cP.

## Description

### TECHNICAL FIELD

The present invention relates to a positive photosensitive resin composition for spray coating, a method for forming a cured film using the same, a cured film, and a semiconductor device.

### BACKGROUND ART

Heretofore, a surface protective film or an interlayer insulating film for a semiconductor element is formed of polybenzoxazole resin or polyimide resin having excellent heat resistance, a great electrical or mechanical property and the like. Further, in order to simplify a process of forming the film, a positive photosensitive resin composition produced by combining the polybenzoxazole resin or the polyimide resin with a quinonediazide compound as a photosensitizer is used (for example, patent document 1).

In general, a spin coating method using a spinner is utilized as a method for coating the positive photosensitive resin composition onto a semiconductor wafer in a semiconductor device manufacturing process. The spin coating method is very good in that an uniform coating film can be formed using a simple machine. However, this method is noneconomic because a large portion of a resin which has been first dispensed on the wafer is spun out from the wafer when spinning it. For this reason, various kinds of other coating methods that can be used instead of the above spin coating method are considered. However, any method having an excellent coating property and a superior economical efficiency has not yet been found. Further, any positive photosensitive resin composition which can be preferably used for such a method has also not yet been found.

Patent document 1: JP-B-1-46862

### DISCLOSURE OF THE INVENTION

It is therefore an object of the present invention to provide a positive photosensitive resin composition for spray coating which can form a film having a very uniform thickness and no pinhole and can economically form such a film as compared with a case that the film is formed using a spin coating method.

In order to achieve the object, the present invention includes the following features (1) to (7):
(1) A positive photosensitive resin composition for spray coating which is used for forming a coating film onto a substrate by spray coating, comprising:
   (A) an alkali soluble resin;
   (B) a compound which generates an acid by the action of light; and
   (C) a solvent,
      wherein the positive photosensitive resin composition for spray coating has a viscosity of 2 to 200 cP.
(2) The positive photosensitive resin composition for spray coating according to the above feature (1), wherein the alkali soluble resin comprises a resin composed of a main chain having at least one of a polybenzoxazole structure and a polyimide structure, and at least one of a hydroxyl group, a carboxyl group, an ether bond and an ester bond each bonded to or contained in the main chain, a resin having a polybenzoxazole precursor structure, a resin having a polyimide precursor structure, or a resin having a polyamide acid ester structure.
(3) The positive photosensitive resin composition for spray coating according to the above feature (1) or (2), wherein the compound which generates the acid by the action of light comprises an ester compound of a phenolic compound and 1,2-naphthoquinone-2-diazide-5-sulfonic acid or 1,2-naphthoquinone-2-diazide-4-sulfonic acid.
(4) The positive photosensitive resin composition for spray coating according to the above feature (1), (2) or (3), wherein the solvent has a boiling point of 210°C or lower and a vapor pressure of 25 kPa or lower at a temperature of 20°C.
(5) A method for forming a cured film having a predetermined pattern on a substrate with the positive photosensitive resin composition for spray coating according to any one of the above features (1) to (4), comprising:
   spray coating the positive photosensitive resin composition onto the substrate to form a coating film on the substrate, baking the coating film, and then exposing and developing it in this order so that the coating film is patterned so as to have a pattern corresponding to the predetermined pattern; and
   curing the patterned coating film to obtain the cured film having the predetermined pattern.
(6) A cured film formed of a cured product of the positive photosensitive resin composition for spray coating according to any one of the above features (1) to (4).
(7) A semiconductor device, comprising:
   a semiconductor substrate;
   a semiconductor element provided on the semiconductor substrate; and
   the cured film according to the above feature (6) and provided on top of the semiconductor element.

### BEST MODE FOR CARRYING OUT THE INVENTION

A positive photosensitive resin composition for spray coating of the present invention is used for forming a coating film onto a substrate by spray coating. The positive photosensitive resin composition for spray coating is characterized by containing (A) an alkali soluble resin, (B) a compound which generates an acid by the action of light and (C) a solvent, and having a viscosity of 2 to 200 cP.
Further, a method for forming a cured film having a predetermined pattern on a substrate with the positive photosensitive resin composition for spray coating of the present invention is characterized by spray coating the positive photosensitive resin composition onto the substrate to form a coating film on the substrate, baking the coating film, and then exposing and developing it in this order so that the coating film is patterned so as to have a pattern corresponding to the predetermined pattern, and curing the patterned coating film to obtain the cured film having the predetermined pattern.
Furthermore, a cured film of the present invention is characterized by being formed of a cured product of the positive photosensitive resin composition for spray coating.
Moreover, a semiconductor device of the present invention is characterized by including a semiconductor substrate, a semiconductor element provided on the semiconductor substrate, and a cured film provided on top of the semiconductor element.
Hereinbelow, each component of the positive photosensitive resin composition of the present invention will be described in detail. In this regard, it is to be noted that the following is illustration and the present invention is not limited to the following at all.

Examples of the (A) alkali soluble resin include cresol type novolak resin, hydroxy styrene resin, acryl resin such as methacrylic acid resin or methacrylic acid ester resin, cyclic olefin resin containing a hydroxyl group, a carboxyl group or the like, polyamide resin, and the like. Among these alkali soluble resins, the polyamide resin is preferably used.
Specifically, examples of such a polyamide resin include: a resin composed of a main chain having at least one of a polybenzoxazole structure and a polyimide structure, and at least one of a hydroxyl group, a carboxyl group, an ether bond and an ester bond each bonded to or contained in the main chain; a resin having a polybenzoxazole precursor structure (that is, a chemical structure which can change to a polybenzoxazole structure); a resin having a polyimide precursor structure (that is, a chemical structure which can change to a polyimide structure); a resin having a polyamide acid ester structure; and the like.
Examples of such a polyamide resin include a polyamide resin represented by the following formula (1). 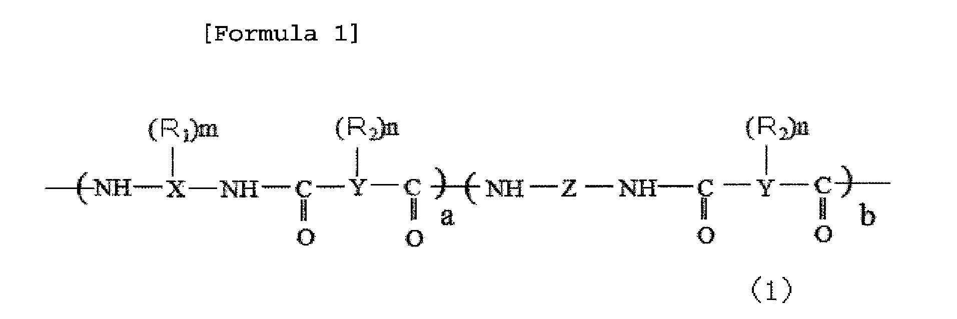 wherein each of "X" and "Y" is an organic group;
wherein each of "a" and "b" represents a mole percent (mol%), a + b = 100, "a" is in the range of 60 to 100 mol%, and "b" is in the range of 0 to 40 mol%;
wherein R¹s may be the same or different, each R¹ is a hydroxyl group or O-R₃;
wherein R²s may be the same or different, each R² is a hydroxyl group, a carboxyl group, O-R₃ or COO-R₃;
wherein "m" is an integer number of 0 to 2, and "n" is an integer number of 0 to 4;
wherein R³ is an organic group having carbon atom(s) of 1 to 15;
wherein in all repeating units, when each R¹ is not the hydroxyl group, at least one of R²s is the carboxyl group, or when each R² is not the carboxyl group, at least one of R¹s is the hydroxyl group; and
wherein "Z" is represented by R₄-Si(R₆)(R₇)-O-Si(R₆)(R₇)-R₅, and each of R₄ to R₇ is an organic group.

The polyamide resin represented by the general formula (1) is obtained by reacting a compound selected from the group comprising diamine, bis(aminophenol) and 2,4-diaminophenol each having the chemical structure of the above mentioned X, and a compound selected from the group comprising tetracarboxylic acid anhydride, trimellitic acid anhydride, dicarboxylic acid, dicarboxylic acid dichloride, a dicarboxylic acid derivative, hydroxydicarboxylic acid and a hydroxydicarboxylic acid derivative each having the chemical structure of the above mentioned Y with each other.
In the case of using the dicarboxylic acid, the dicarboxylic acid is converted into an activated ester type dicarboxylic acid derivative by reacting, in advance, it with 1-hydroxy-1,2,3-benzotriazole or the like, and the activated ester type dicarboxylic acid derivative may be used in the above reaction. This makes it possible to improve a reaction yield of the polyamide resin represented by the general formula (1) .

In the polyamide resin represented by the general formula (1), each of O-R₃ as the substituent of the "X" and O-R₃ or COO-R₃ as the substituent of the "Y" is a group protected by the R³ which is the organic group having carbon atom(s) of 1 to 15 in order to adjust solubility of a hydroxyl group or a carboxyl group in an alkali aqueous solution. In this regard, the hydroxyl group or the carboxyl group may be protected if needed.
Examples of the R₆ include a formyl group, a methyl group, an ethyl group, a propyl group, an isopropyl group, a tertiary butyl group, a tertiary butoxycarbonyl group, a phenyl group, a benzyl group, a tetrahydrofuranyl group, a tetrahydropyranyl group, and the like.

In the case where this polyamide resin is heated, it is dehydrated and cyclized to obtain a thermostabile resin such as polyimide resin, polybenzoxazole resin or a copolymer thereof.

Examples of the "X" shown in the general formula (1) include groups each represented by the following formula.

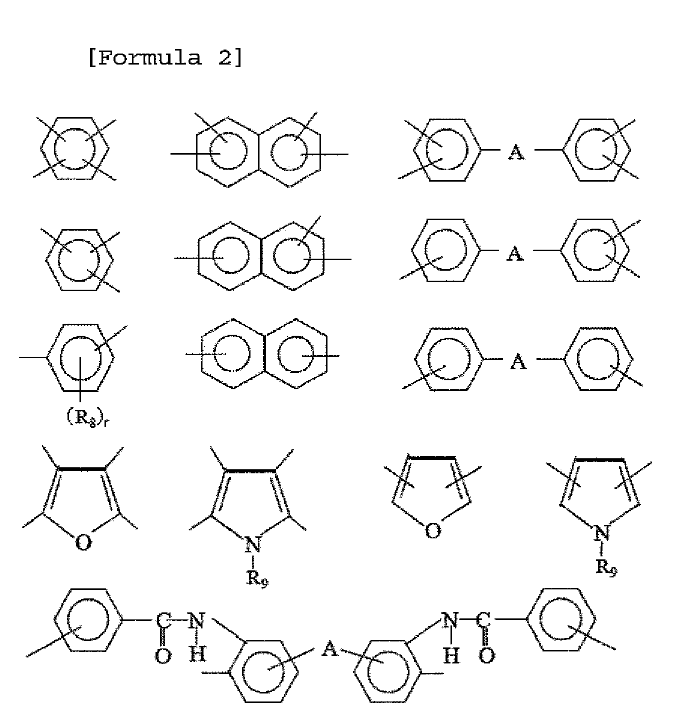

wherein "A" is CH₂, C(CH₃)₂, O, S, SO₂, CO, NHCO, C(CF₃)₂ or a single bond;
wherein R₈s may be the same or different, each R₈ is an alkyl group, an alkyl ester group or a halogen atom;
wherein "r" is an integer number of 0 to 2; and
wherein R₉ is a hydrogen atom, an alkyl group, an alkyl ester group or a halogen atom.

Among these groups, the "X" is more preferably selected from groups each represented by the following formula, and two or more of the groups selected may be used in combination.

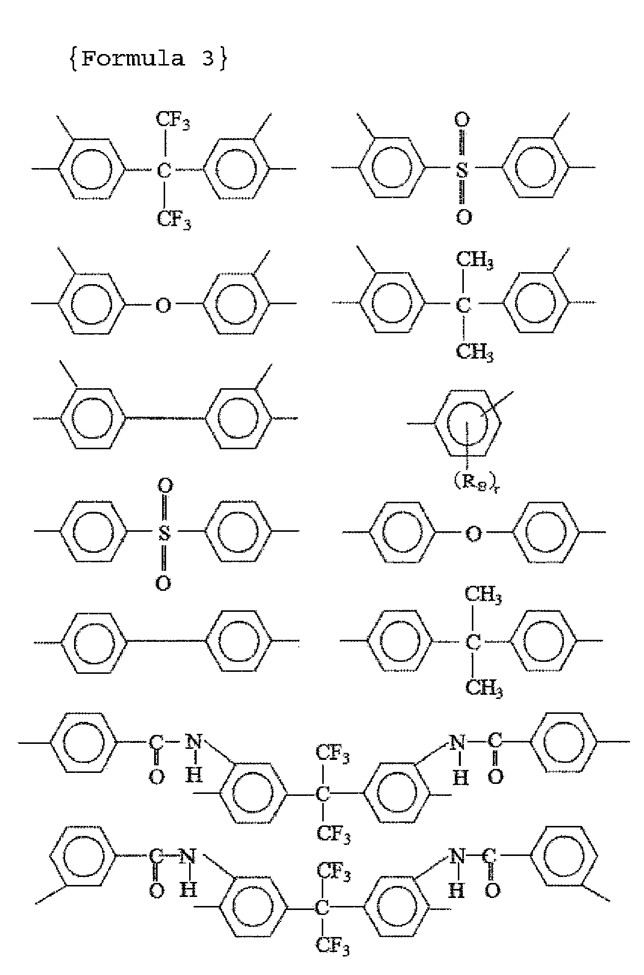

wherein R₈s may be the same or different, each R₈ is an alkyl group, an alkyl ester group or a halogen atom: and
wherein "r" is an integer number of 0 to 2.

Examples of the "Y" shown in the general formula (1) include groups each represented by the following formula.

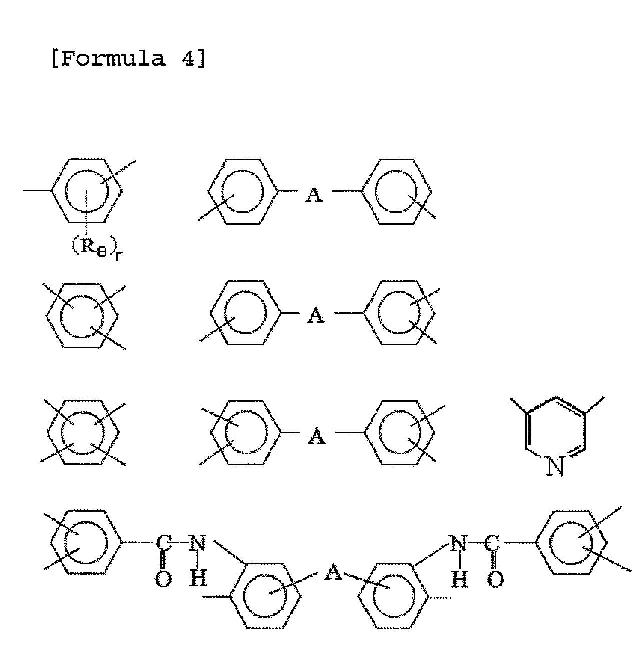

wherein "A" is CH₂, C(CH₃)₂, O, S, SO₂, CO, NHCO, C(CF₃)₂ or a single bond;
wherein R₈s may be the same or different, each R₈ is an alkyl group, an alkyl ester group or a halogen atom; and
wherein "r" is an integer number of 0 to 2.

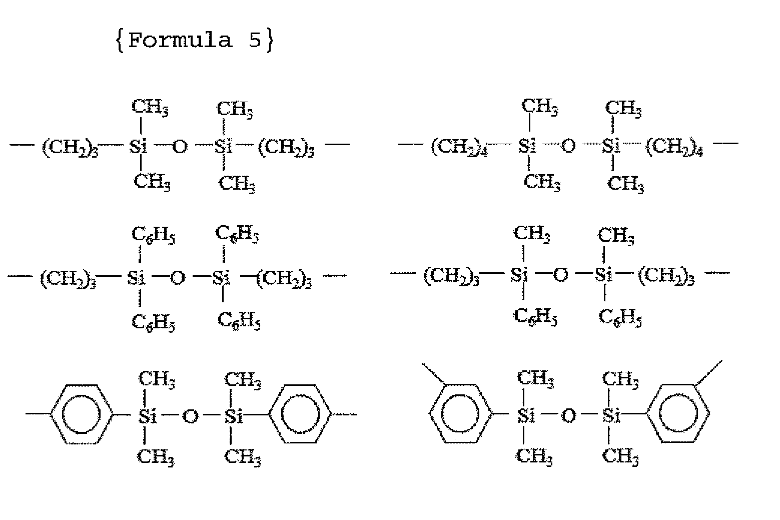

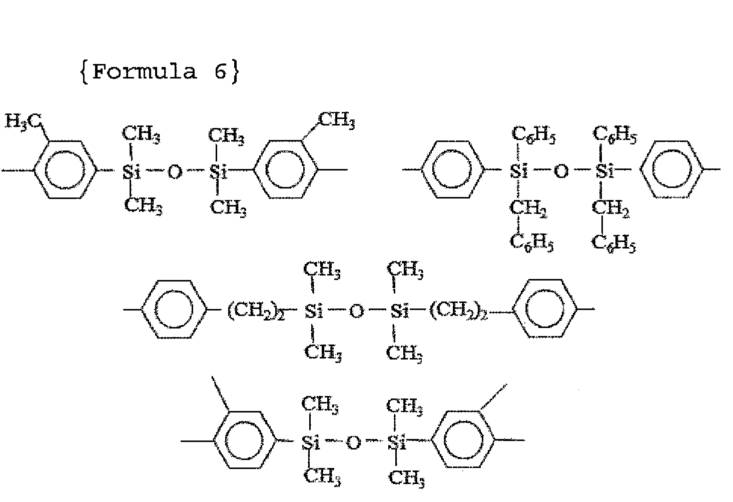

Among these groups, the "Y" is more preferably selected from groups each represented by the following formula, and two or more of the groups selected may be used in combination.

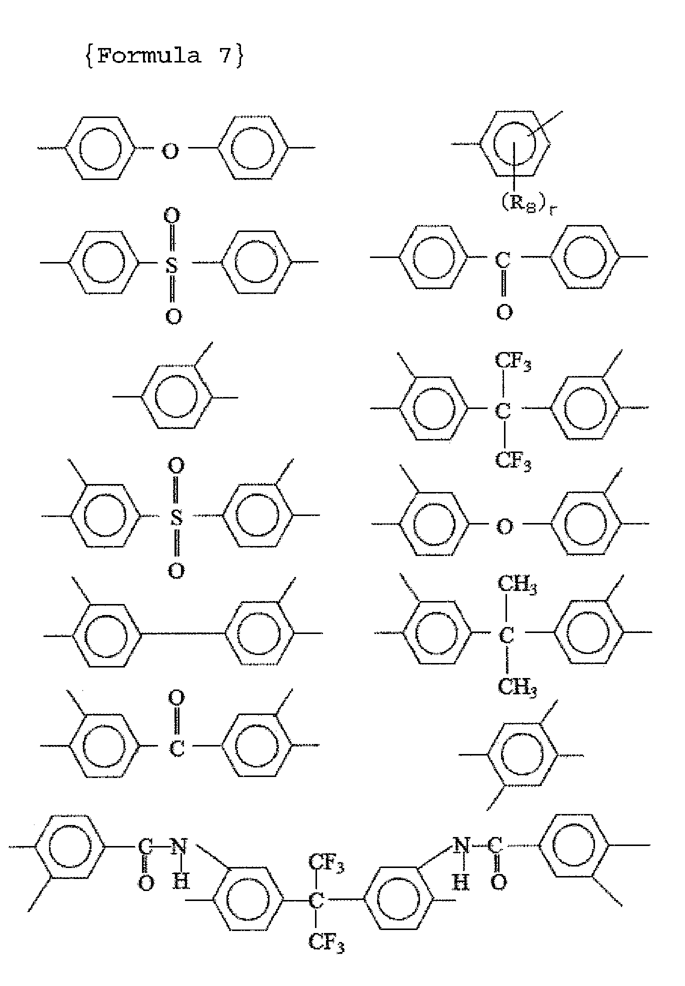

wherein R₈s may be the same or different, each R₈ is an alkyl group, an alkyl ester group or a halogen atom; and
wherein "r" is an integer number of 0 to 2.

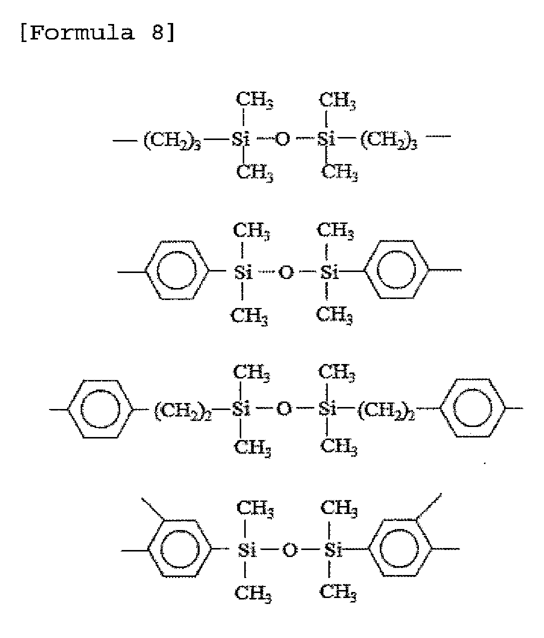

In the general formula (1), "b" which represents the mole percent of the repeating unit including the "Z" and the "Y" may be zero.

Further, in the present invention, an end of the main chain of the polyamide resin represented by the general formula (1) is desirably capped from the viewpoint of storage stability thereof. For the capping, a derivative having an aliphatic group containing at least one of an alkenyl group and an alkynyl group or a cyclic compound group can be introduced into the end of the main chain thereof as an acid derivative or an amine derivative.
Specifically, the polyamide resin represented by the general formula (1) is synthesized by reacting a compound selected from the group comprising diamine, bis(aminophenol) and 2,4-diaminophenol each having the chemical structure of the above mentioned X, and a compound selected from the group comprising tetracarboxylic acid anhydride, trimellitic acid anhydride, dicarboxylic acid, dicarboxylic acid dichloride, a dicarboxylic acid derivative, hydroxydicarboxylic acid and a hydroxydicarboxylic acid derivative each having the chemical structure of the above mentioned Y with each other. Thereafter, an amino group which is the end of the main chain of the polyamide resin is preferably capped as an amide using an acid anhydride or acid derivative having the aliphatic group containing at least one of the alkenyl group and the alkynyl group or the cyclic compound group.
Examples of the end capping functional group include groups each represented by the following formula.

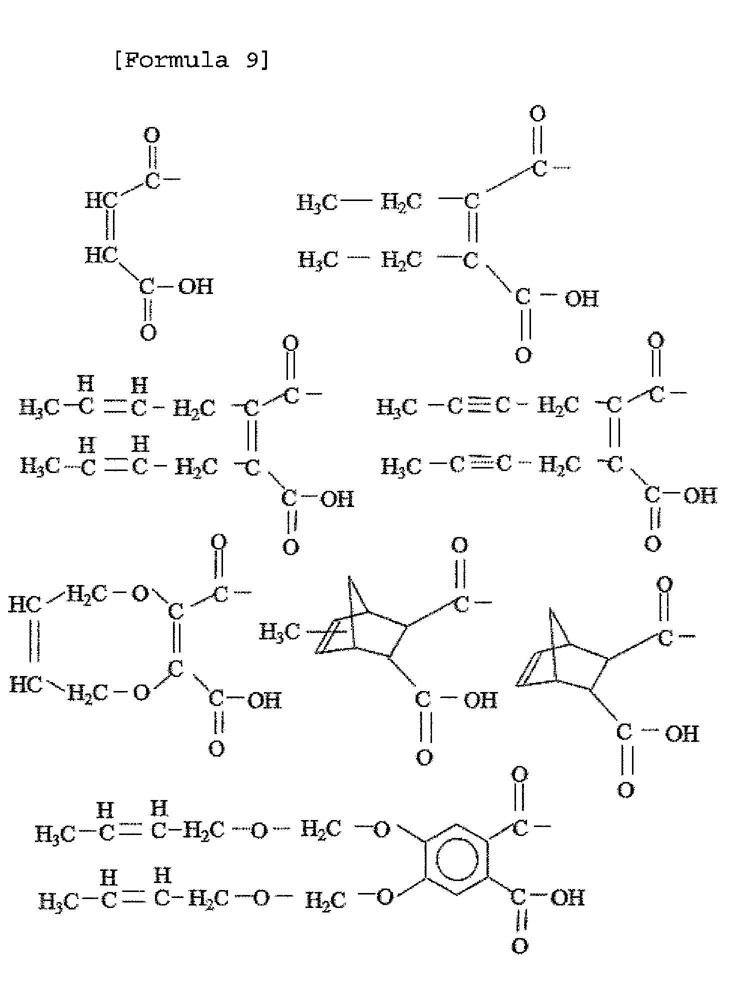

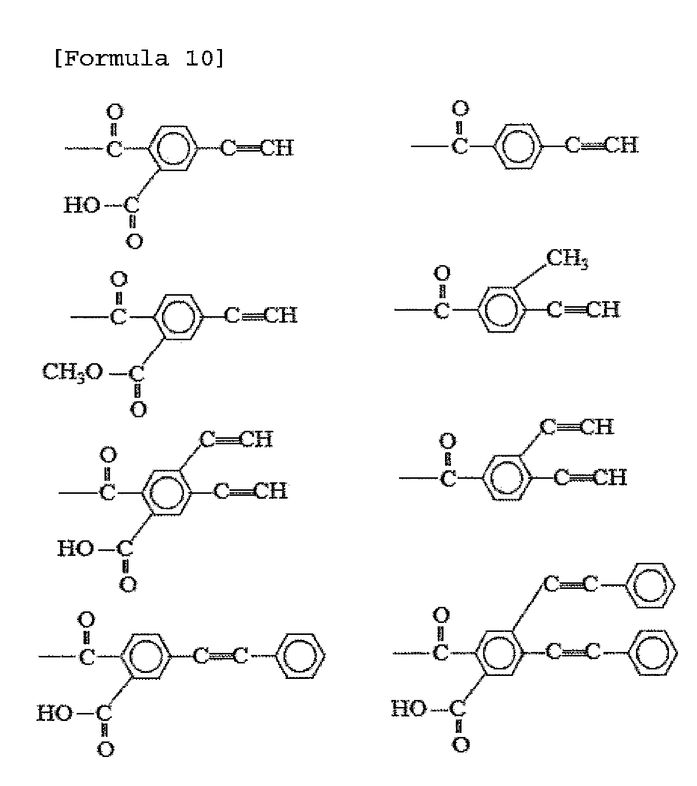

Among these groups, the end capping functional group is more preferably selected from groups each represented by the following formula. These groups selected may be used singly or in combination of two or more thereof. The method for capping the end of the main chain of the polyamide resin is not limited to the above described method. An acid group which is the end of the main chain of the polyamide resin may be capped as an amide using an amine derivative having the aliphatic group containing at least one of the alkenyl group and the alkynyl group or the cyclic compound group.

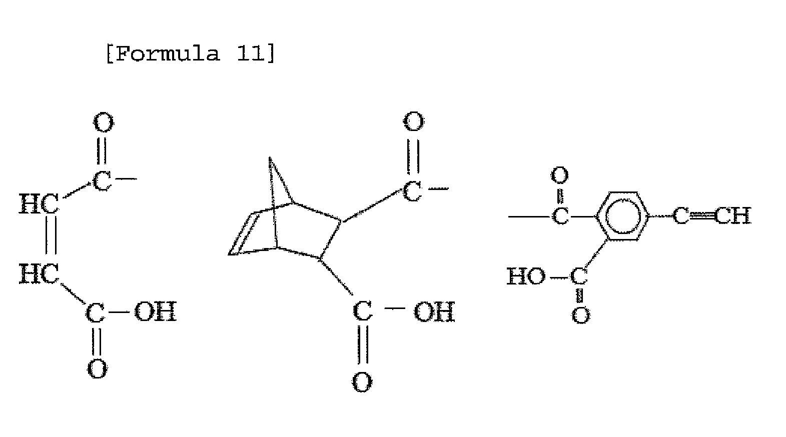

An amount of a photosensitizer (B) having a specific chemical structure which is a naphthoquinone diazide sulfonic acid ester compound of phenol is preferably in the range of 1 to 50 parts by weight, and more preferably in the range of 10 to 40 parts by weight, with respect to 100 parts by weight of the alkali soluble resin.
If the amount of the photosensitizer (B) is the above lower limit value or more, since an unexposed portion of the coating film has a resistance property for the alkali aqueous solution, it is possible to finely pattern the coating film. This makes it possible to highly maintain remaining film ratio and resolution of the coating film, and to improve sensitivity thereof. On the other hand, if the amount of the photosensitizer (B) is the above upper limit value or less, it is possible to highly maintain sensitivity and resolution of the coating film by moderately preventing occurrence of a scum and lowering of transparency of the coating film which would occur due to the photosensitizer itself. Further, it is also possible to make remaining film ratio of the coating film high even after being cured by preventing contraction thereof due to decomposed components which would be generated when the coating film is cured.

Examples of the compound (B) which generates the acid by the action of light include an onium salt, a halogenated organic compound, a quinone diazide compound, a a,a-bis(sulfonyl) diazomethane compound, a a-carbonyl-a-sulfonyl-diazomethane compound, a sulfone compound, an organic acid ester compound, an organic acid amide compound, an organic acid imide compound and the like. Concrete examples of the onium salt include a diazonium salt, an ammonium salt, an iodonium salt, a sulfonium salt, a phosphonium salt, an arsonium salt, an oxonium salt and the like each unsubstituted or substituted symmetrically or unsymmetrically with alkyl groups, alkenyl groups, aralkyl groups, aromatic groups or heterocyclic groups.
As long as a compound can produce a counter anion together with the above onium salt, it is not limited to a specific type. Examples of such a compound include boric acid, arsonium acid, phosphoric acid, antimonic acid, sulfate salt, and carboxylic acid and halide. A halogenated organic compound is not limited to a specific type as long as it is halide of an organic compound. As the halogenated organic compound, various kinds of known compounds can be used.
Examples of the halogenated organic compound include a halogen containing oxadiazole compound, a halogen containing triazine compound, a halogen containing acetophenone compound, a halogen containing benzophenone compound, a halogen containing sulfoxide compound, a halogen containing sulfone compound, a halogen containing thiazole compound, a halogen containing oxazole compound, a halogen containing triazole compound, a halogen containing 2-pyrone compound, a halogen containing aliphatic hydrocarbon compound, a halogen containing aromatic hydrocarbon compound, another halogen containing heterocyclic compound, a sulfenyl halide compound and the like.
Concrete examples of the halogenated organic compound include: a halogen containing flame retardant such as tris(2,3-dibromo propyl) phosphate, tris(2,3-dibromo-3-chloro propyl) phosphate, chloro tetrabromo ethane, hexachloro benzene, hexabromo benzene, hexabromo cyclododecane, hexabromo biphenyl, tribromo phenyl allyl ether, tetrachloro bisphenol A, tetrabromo bisphenol A, bis (bromo ethyl ether) tetrabromo bisphenol A, bis (chloro ethyl ether) tetrachloro bisphenol A, tris(2,3-dibromo propyl) isocyanurate, 2,2-bis(4-hydroxy-3,5-dibromo phenyl) propane, 2,2-bis(4-hydroxyethoxy-3,5-dibromo phenyl) propane; an organic chloro agricultural chemical such as dichloro diphenyl trichloro ethane, benzene hexachloride, pentachloro phenol, 2,4,6-trichloro phenyl-4-nitrophenyl ether, 2,4-dichloro phenyl-3'-methoxy-4'-nitrophenyl ether, 2,4-dichloro phenoxy acetic acid, 4,5,6,7-tetrachloro fthalide, 1,1-bis(4-chloro phenyl) ethanol, 1,1-bis(4-chloro phenyl)-2,2,2-trichloro ethanol, ethyl-4,4-dichloro benzilate, 2,4,5,4'-tetrachloro diphenyl sulfide, 2,4,5,4'-tetrachloro diphenyl sulfone; and the like.
Concrete examples of the quinone diazide compound include an o-quinoneazide compound such as 1,2-benzoquinonediazide-4-sulfonic acid ester, 1,2-naphthoquinonediazide-4-sulfonic acid ester, 1,2-naphthoquinonediazide-5-sulfonic acid ester, 1,2-naphthoquinonediazide-6-sulfonic acid ester, 2,1-naphthoquinonediazide-4-sulfonic acid ester, 2,1-naphthoquinonediazide-5-sulfonic acid ester, 2,1-naphthoquinonediazide-5-sulfonic acid ester, another sulfonic acid ester of a quinonediazide derivative, 1,2-benzoquinonediazide-4-sulfonic acid chloride, 1,2-naphthoquinonediazide-4-sulfonic acid chloride, 1,2-naphthoquinonediazide-5-sulfonic acid chloride, 1,2-naphthoquinonediazide-6-sulfonic acid chloride, 2,1-naphthoquinonediazide-4-sulfonic acid chloride, 2,1-naphthoquinonediazide-5-sulfonic acid chloride, 2,1-naphthoquinonediazide-6-sulfonic acid chloride, and another sulfonic acid chloride of a quinoneazide derivative.
Concrete examples of the a,a-bis(sulfonyl) diazomethane compound include a,a-bis (sulfonyl) diazomethane unsubstituted or substituted symmetrically or unsymmetrically with alkyl groups, alkenyl groups, aralkyl groups, aromatic groups or heterocyclic groups, and the like. Concrete examples of the a-carbonyl-a-sulfonyl-diazomethane compound include a-carbonyl-a-sulfonyl-diazomethane unsubstituted or substituted symmetrically or unsymmetrically with alkyl groups, alkenyl groups, aralkyl groups, aromatic groups or heterocyclic groups, and the like.
Concrete examples of the sulfone compound include a sulfone compound or disulfone compound unsubstituted or substituted symmetrically or unsymmetrically with alkyl groups, alkenyl groups, aralkyl groups, aromatic groups or heterocyclic groups, and the like. Concrete examples of the organic acid ester compound include carboxylic acid ester or sulfonic acid ester unsubstituted or substituted symmetrically or unsymmetrically with alkyl groups, alkenyl groups, aralkyl groups, aromatic groups or heterocyclic groups, and the like.
Concrete examples of the organic acid amide compound include carboxylic amide or sulfonic amide unsubstituted or substituted symmetrically or unsymmetrically with alkyl groups, alkenyl groups, aralkyl groups, aromatic groups or heterocyclic groups, and the like. Concrete examples of the organic acid imide compound include carboxylic imide or sulfonic imide unsubstituted or substituted symmetrically or unsymmetrically with alkyl groups, alkenyl groups, aralkyl groups, aromatic groups or heterocyclic groups, and the like.
These compounds which can generate the acid by being broken due to irradiation of active beam may be used singly or in combination of two or more thereof.

Among these compounds, an ester compound of a phenolic compound and 1,2-naphthoquinone-2-diazide-5-sulfonic acid or 1,2-naphthoquinone-2-diazide-4-sulfonic acid is more preferably used. Examples of such an ester compound include the following compounds, but are not limited thereto. Further, these ester compounds may be used in combination of two or more thereof.

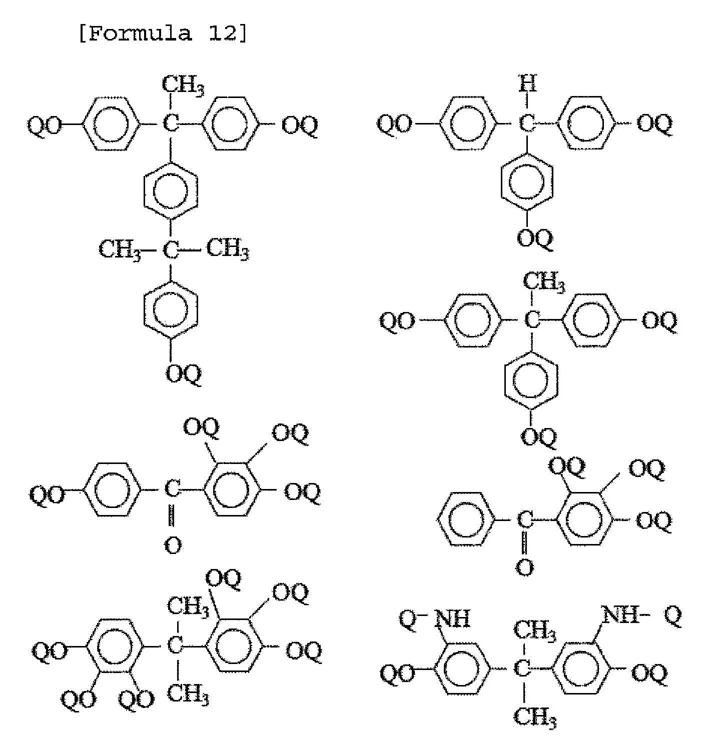

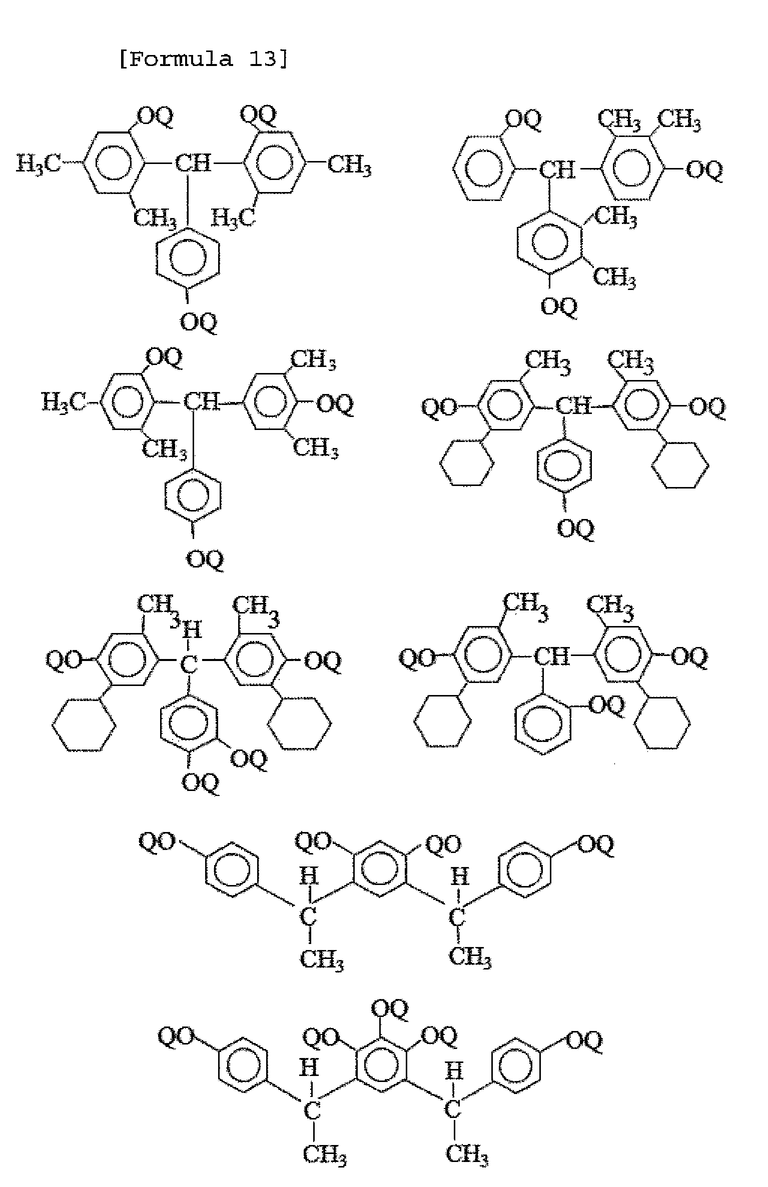

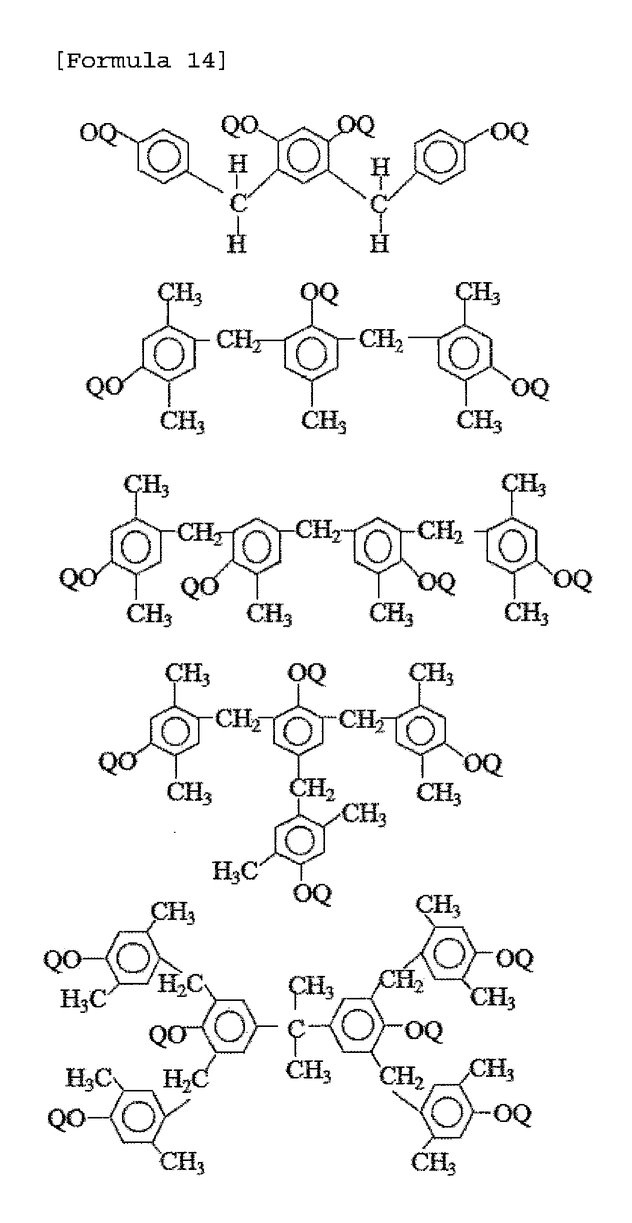

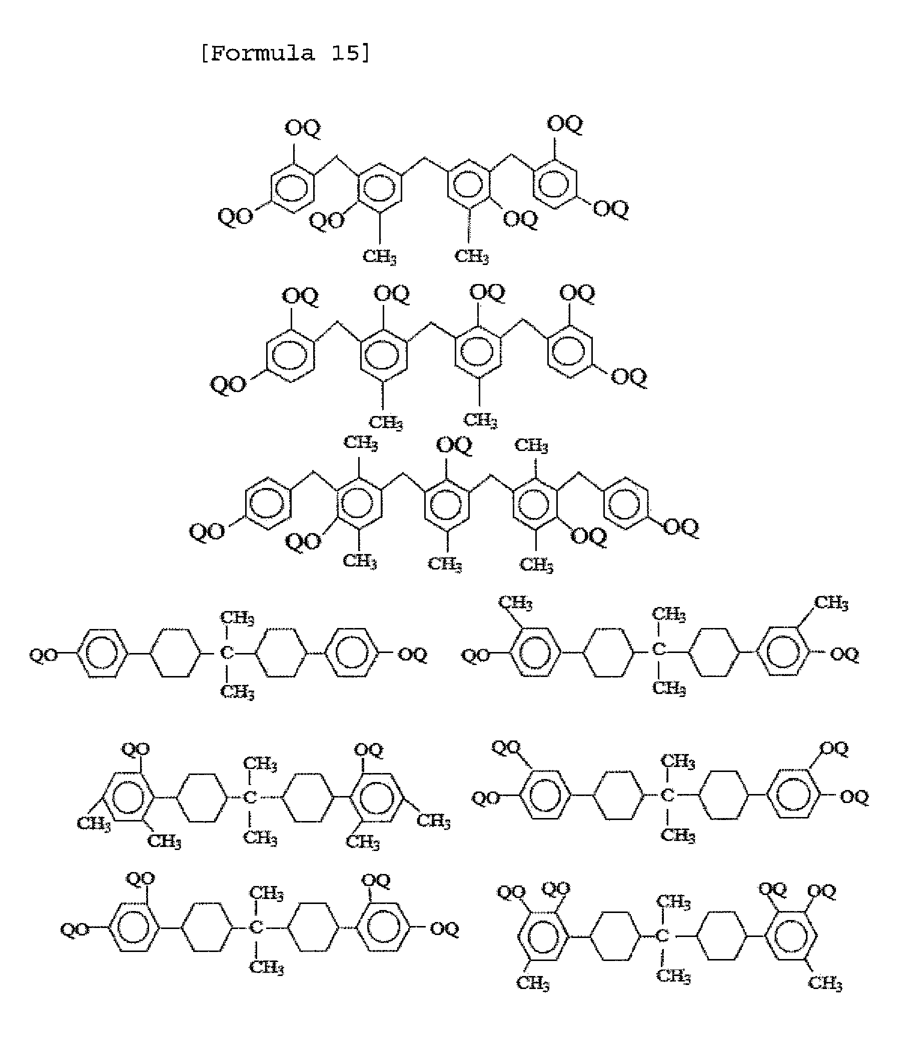

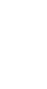

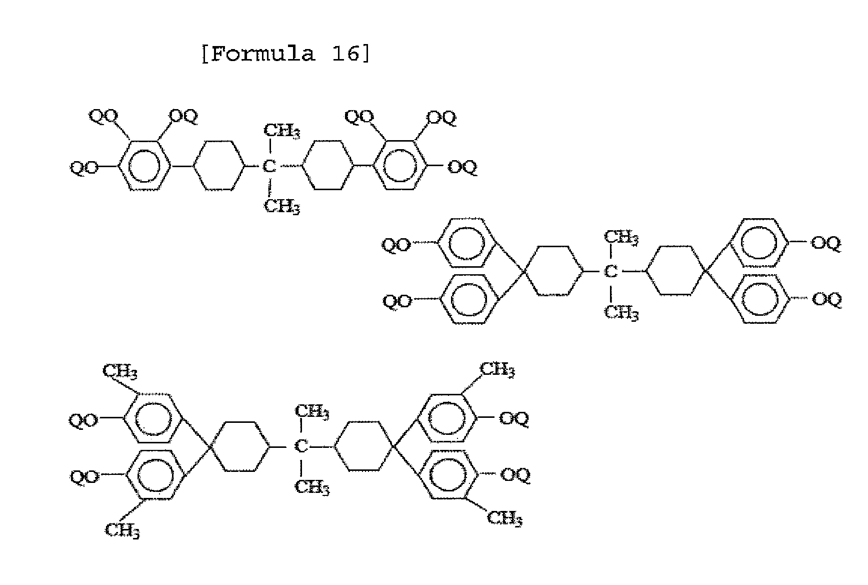

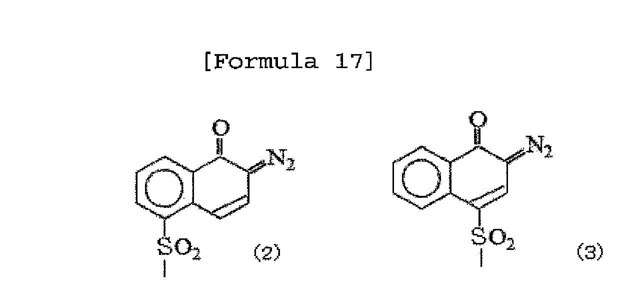

wherein "Q" is a hydrogen atom, a group represented by a formula (2) or a group represented by a formula (3); and
wherein in each compound, at least one of "Q"s is the group represented by the formula (2) or the group represented by the formula (3).

As described above, the amount of the compound which generates the acid by the action of light is in the range of 1 to 50 parts by weight, with respect to 100 parts by weight of the alkali soluble resin. If the amount of the compound is lower than 1 part by weight, there is a case that it is difficult to pattern the coating film (polyamide resin). On the other hand, if the amount of the compound exceeds 50 parts by weight, there is a case that sensitivity of the coating film is severely lowered.

Examples of the solvent used in the present invention include γ-butyrolactone, N-methyl-2-pyrolidone, N,N-dimethyl acetamide, N,N-dimethyl formamide, dimethyl sulfoxide, diethylene glycol dimethyl ether, diethylene glycol diethyl ether, diethylene glycol dibutyl ether, propylene glycol monomethyl ether, dipropylene glycol monomethyl ether, propylene glycol monomethyl ether acetate, methyl lactate, ethyl lactate, butyl lactate, methyl-1,3-butylene glycol acetate, 1,3-butylene glycol-3-monomethyl ether, methyl pyruvate, ethyl pyruvate, methyl-3-methoxy propionate, amyl acetate, t-butyl acetate, ethyl propionate, 2-methyl tetrahydrofuran, ethyl acetate and the like, and these solvents may be used singly or in combination thereof.

Among these solvents, a solvent having a boiling point of 141°C or higher but 210°C or lower such as the γ-butyrolactone, the amyl acetate, the methyl lactate, the ethyl lactate or the butyl lactate is preferably used. This is because it is possible to form a coating film having an uniform thickness while suppressing generation of pinholes when coating the positive photosensitive resin composition for spray coating onto a wafer.
Further, in the case where the positive photosensitive resin composition is used for forming an insulating film onto an internal surface defining a hole provided through a semiconductor element or semiconductor element mounting substrate in a thickness thereof, a solvent having a boiling point of 120°C or lower (that is, a solvent having high volatility) such as the propylene glycol monomethyl ether, the t-butyl acetate, the ethyl propionate, the 2-methyl tetrahydrofuran, the ethyl acetate, acetone, MEK or alcohol is preferably used. This makes it possible to prevent move of the coated positive photosensitive resin composition for spray coating toward the under side of the hole.
On the other hand, in the case where a solvent having a vapor pressure of 25 kPa or higher at a temperature of 20°C is used, viscosity of the positive photosensitive resin composition remarkably increases due to volatilization of the solvent during storage thereof at room temperature. Therefore, in order to appropriately satisfy both volatility of the positive photosensitive resin composition when coating it and viscosity stability thereof during the storage at room temperature, a solvent having a vapor pressure of 25 kPa or lower at a temperature of 20°C such as the t-butyl acetate, the ethyl propionate or the ethyl acetate is more preferably used.

Although the solvent having the boiling point of 120°C or lower is singly used, in order to appropriately satisfy volatility of the positive photosensitive resin composition when coating it, suppression in generation of pinholes and formation of a coating film having an uniform thickness, it is preferably used in combination with the above solvent having the boiling point of 141°C or higher but 210°C or lower.
In this case, a mixing ratio of the solvents is preferably 51 to 90 wt% of the solvent having the boiling point of 141°C or higher but 210°C or lower with respect to 49 to 10 wt% of the solvent having the boiling point of 120°C or lower. In the case where the volatility of the positive photosensitive resin composition when coating it is to be remarkably improved, the solvent may contain a solvent having a boiling point of 99°C or lower in an amount of 50 to 100 wt%.

A viscosity of the positive photosensitive resin composition of the present invention is in the range of 2 to 200 cP, and preferably in the range of 5 to 100 cP. By setting the viscosity of the positive photosensitive resin composition within the above range, it is possible to obtain an effect of suppressing dripping thereof from the center of a nozzle of a sprayer, an effect of uniformly coating it onto a substrate and an effect of suppressing generation of pinholes.
The viscosity of the positive photosensitive resin composition can be set by appropriately adjusting a mixing ratio of the (A) alkali soluble resin, the (B) compound which generates the acid by the action of light and the (C) solvent.

Further, the viscosity of the positive photosensitive resin composition of the present invention can be determined using a measurement machine provided with a rotor ("TVE-20L form viscosity meter cone plate type" produced by TOKIMEC). Specifically, a standard rotor (1°34', R = 2.4 cm) is used as the rotor and rotated at a rotation number of 10 rpm and a temperature of 25°C. After 5 minutes rotation, the viscosity of the positive photosensitive resin composition is measured.

Furthermore, in the present invention, in order to improve an ease of the spray coating, the positive photosensitive resin composition may further contain a surface activating agent. Examples of the surface activating agent include a fluoro type surface activating agent, a siloxane type surface activating agent and a non-fluoro type surface activating agent. The fluoro type surface activating agent has a chemical structure containing perfluoro alkyl groups.
Concrete examples of the fluoro type surface activating agent include MEGAFACE F-470, F-471, F-472SF, F-474, F-475, R-30, F-477, F-478, F-479, BL-20, R-61 and R-90 each produced by Dainippon Ink Chemicals Incorporated, FC-170C and FC-4430 each produced by Sumitomo 3M Ltd., and the like, but are not limited thereto. Concrete examples of the siloxane type surface activating agent include a polyalkyl-modified siloxane type surface activating agent, a polyester-modified siloxane type surface activating agent, an aralkyl-modified siloxane type surface activating agent, an alkyl aralkyl-modified siloxane type surface activating agent, and the like, but are not limited thereto.
Concrete examples of the non-fluoro type surface activating agent include a nonion type surface activating agent such as polyoxyethylene lauryl ether, polyoxyethylene oleyl ether, polyoxyethylene octyl phenyl ether, polyoxyethylene nonyl phenyl ether, polyethylene glycol dilaurylate or polyethylene glycol distearate, and a surface activating agent composed of an acrylic polymer or a methacrylic polymer, but are not limited thereto.

The positive photosensitive resin composition according to the present invention may optionally contain additives such as a silane coupling agent.

A method for using the positive photosensitive resin composition of the present invention will be described.
The positive photosensitive resin composition of the present invention is spray coated onto a substrate such as a semiconductor element mounting substrate, a ceramics substrate or an aluminium substrate using a spray coating machine, to form a coating film. The positive photosensitive resin composition of the present invention is preferably used for forming an insulating film to be provided on the semiconductor element mounting substrate or an insulating film to be provided on an internal surface defining a hole formed on a reverse face of the semiconductor element mounting substrate.
Further, as for the spray coating machine, "Delta Altra Spray" produced by SUSS MicroTec, or the like can be used. The positive photosensitive resin composition of the present invention can be spray coated using a general spray gun or the like. The spray gun is not particularly limited to a specific type, but is preferably provided with a nozzle having a small diameter from the viewpoint of uniform coating of the positive photosensitive resin composition. In general, a spray gun provided with a nozzle having a diameter of 0.1 to 2 mm can be used.
Furthermore, the spray coating is preferably performed at a spray pressure in the range of 1.0 to 5.0 kg/cm². If the spray pressure is very low, a drying time of the positive photosensitive resin composition spray coated tends to vary widely, thereby lowering an ease of the coating. On the other hand, if the spray pressure is very high, a tip of the nozzle tends to be clogged with the positive photosensitive resin composition.

In the case where the positive photosensitive resin composition is coated onto the semiconductor element mounting substrate, a coating amount thereof is set to a specific value so that the coating film after being cured (that is, a cured film) can have a thickness of 0.1 to 30 µm.
If the thickness of the coating film is less than the above lower limit value, it becomes difficult that the cured film acts as a protective film of a semiconductor element sufficiently. On the other hand, if the thickness of the coating film exceeds the above upper limit value, it becomes difficult that a refined pattern is obtained, and throughput of the coating film is lowered by being long in processing it.
Next, the coating film is pre-baked at a temperature of 60 to 130°C so that it is dried to obtain a dry film (dried coating film), and then a predetermined pattern of the dry film is irradiated with an actinic ray. As the actinic ray, an X-ray, an electron ray, an ultraviolet ray, a visible ray or the like can be used, but an actinic ray having a wavelength of about 200 to 500 nm is preferably used.

Next, portions of the dry film irradiated with the actinic ray are dissolved and removed using a developing solution to obtain a relief pattern (patterned coating film).
As for the developing solution, an aqueous solution containing inorganic alkalis such as sodium hydroxide, potassium hydroxide, sodium carbonate, sodium silicate, sodium meta-silicate and ammonia water; an aqueous solution containing organic alkalis such as primary amines (e.g., ethyl amine and n-propyl amine), secondary amines (e.g., diethyl amine and di-n-propyl amine), tertiary amines (e.g., triethyl amine and methyl diethyl amine), alcohol amines (e.g., dimethyl ethanol amine and triethanol amine), and quaternary ammonium salts (e.g., tetramethyl ammonium hydroxide and tetraethyl ammonium hydroxide); an aqueous solution in which a water-soluble organic solvent such as alcohol (e.g., methanol or ethanol) or a surface active agent is added to the above aqueous solution in an adequate amount; and the like can be preferably used.
As for a developing method, a puddle method, a dipping method, a spray method, an ultrasonic sound method or the like can be used.

Next, the relief pattern formed by the development is rinsed or washed. As for a rinse solution, a distilled water is used. Thereafter, the relief pattern is subjected to a heat treatment so that ring closure structures such as oxazole rings and imide rings are formed within the alkali soluble resin to thereby obtain a final pattern (a cured film having a predetermined pattern) having an abundance of heat resistance.

The positive photosensitive resin composition of the present invention is suitable to be used for forming not only an insulating film for a semiconductor element, but also an interlayer insulating film for a multilayer circuit board, a cover coat film for a flexible copper-clad plate, a solder resist film, a liquid crystal orientation film, an interlayer insulating film for elements provided in a display device, or the like.

### Examples

Hereinbelow, the present invention will be described in detail based on the following Examples.

### (Example 1)

### [Synthesis of alkali soluble resin]

First, 0.016 mol of a mixture of dicarboxylic acid ester derivatives obtained by reacting 4.13 g (0.016 mol) of diphenyl ether-4,4'-dicarboxylic acid with 4.32 g (0.032 mol) of 1-hydraxy-1,2,3-benzotriazole, and 7.33 g (0.020 mol) of hexafluoro-2,2-bis(3-amino-4-hydroxyphenyl) propane were put into a four-necked separable flask equipped with a thermometer, a stirrer, a raw material input port and a dry nitrogen gas-introducing tube.
Next, 57.0 g of N-methyl-2-pyrrolidone was added to the above materials so that they were dissolved into the N-methyl-2-pyrrolidone to obtain a liquid solution, and then the liquid solution was heated at 75°C for 12 hours using an oil bath so that the dicarboxylic acid ester derivatives and the hexafluoro-2,2-bis(3-amino-4-hydroxyphenyl) propane were reacted with each other.
Next, 7 g of N-methyl-2-pyrrolidone, in which 1.31 g (0.008 mol) of 5-norbornene-2,3-dicarboxylic acid anhydride was dissolved, was added to the liquid solution, and then the liquid solution was stirred for 12 hours so that the reaction was completed to obtain a reaction mixture.
The reaction mixture was passed through a filter, and then put into a liquid solution containing water and methanol in a volume ratio of 3:1 so that a precipitate was produced in the liquid solution. Thereafter, the produced precipitate was filtered and rinsed with water sufficiently, and then dried under a vacuum condition to thereby obtain a desired alkali soluble resin (A-1). 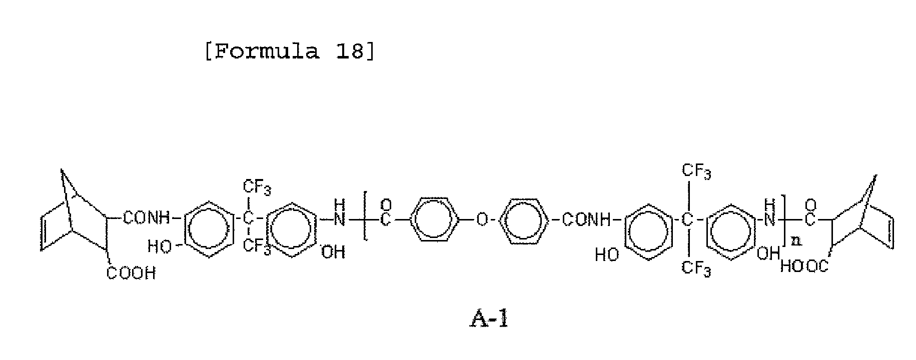 wherein "n" is in the range of 15 to 20.

### [Production of positive photosensitive resin composition]

10 g of the above synthesized alkali soluble resin (A-1) and 2 g of photosensitive diazoquinone (B-1) as a compound which generates an acid by the action of light were dissolved into γ-butyrolactone (C-1) as a solvent, and then passed through a filter having a pore size of 0.2 µm and made of fluororesin to thereby obtain a positive photosensitive resin composition having a viscosity of 30 cP.

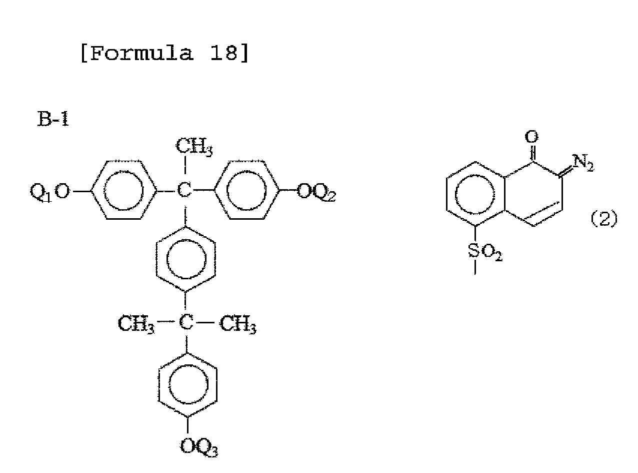

wherein 75% of Q1, Q2 and Q3 is a group represented by a formula (2) and 25% thereof is a hydrogen atom.

### [Characteristic evaluation]

The positive photosensitive resin composition was spray coated onto a 8 inch silicon wafer (having a thickness of 725 µm) using a spray gun at an air pressure of 2 kg/cm² to form a coating film, and then was pre-baked at 120°C for 4 minutes using a hot plate to thereby obtain a dry film (dried coating film) having a thickness of about 7 µm on the silicon wafer.
Thereafter, the dry film was irradiated with an ultraviolet ray using an i-ray stepper ("4425i" produced by Nikon Corporation) through a mask ("test chart No.1", produced by TOPPAN PRINTING Co., LTD.), while adjusting an exposure amount thereof. In this regard, it is to be noted that the mask had patterns to be not removed and patterns to be removed, and a width of each pattern was in the range of 0.88 to 50 µm.
Next, the silicon wafer was immersed into a 2.38% tetramethyl ammonium hydroxide aqueous solution for 50 seconds so that irradiated portions of the dry film were removed to form removed portions in the dry film, and then was rinsed for 10 seconds with a purified water.
As a result, the irradiated portions irradiated with the ultraviolet ray having the exposure amount of 180 mJ/cm² or more were remained to form a pattern (cured film). Therefore, it can be confirmed that sensitivity of the dry film (positive photosensitive resin composition) was 180 mJ/cm². Further, a thickness of the dry film after being developed was 6.2 µm and resolution thereof was 3 µm, which were very good values.

### [Example 2]

The solvent used in Example 1 was changed into a mixture of γ-butyrolactone and ethyl acetate (C-2). A mixing ratio of the γ-butyrolactone and the ethyl acetate was 45/55. Production of a positive photosensitive resin composition and characteristic evaluation were performed in the same manner as Example 1. A thickness of the dry film after being developed was 6.3 µm, sensitivity thereof was 165 mJ/cm², and resolution thereof was 3 µm.

### [Example 3]

The solvent used in Example 1 was changed into a mixture of γ-butyrolactone and 2-methyl tetrahydrofuran (C-3). A mixing ratio of the γ-butyrolactone and the 2-methyl tetrahydrofuran was 40/60. Production of a positive photosensitive resin composition and characteristic evaluation were performed in the same manner as Example 1. A thickness of the dry film after being developed was 6.0 µm, sensitivity thereof was 195 mJ/cm², and resolution thereof was 3 µm.

### [Example 4]

The solvent used in Example 1 was changed into a mixture of γ-butyrolactone and ethyl propionate (C-4). A mixing ratio of the γ-butyrolactone and the ethyl propionate was 40/60. Production of a positive photosensitive resin composition and characteristic evaluation were performed in the same manner as Example 1. A thickness of the dry film after being developed was 6.2 µm, sensitivity thereof was 155 mJ/cm², and resolution thereof was 3 µm.

### [Example 5]

The solvent used in Example 1 was changed into a mixture of γ-butyrolactone and t-butyl acetate (C-5). A mixing ratio of the γ-butyrolactone and the t-butyl acetate was 55/45. Production of a positive photosensitive resin composition and characteristic evaluation were performed in the same manner as Example 1. A thickness of the dry film after being developed was 6.0 µm, sensitivity thereof was 175 mJ/cm², and resolution thereof was 3 µm.

### INDUSTRIAL APPLICABILITY

According to the present invention, it is possible to provide a positive photosensitive resin composition for spray coating which can form a film having a very uniform thickness and no pinhole and can economically form the film as compared with a case that the film is formed using a spin coating method. Thus, the present invention has industrial applicability.

## Claims

1. A positive photosensitive resin composition for spray coating which is used for forming a coating film onto a substrate by spray coating, comprising:
(A) an alkali soluble resin;
(B) a compound which generates an acid by the action of light; and
(C) a solvent,
wherein the positive photosensitive resin composition for spray coating has a viscosity of 2 to 200 cP.

2. The positive photosensitive resin composition for spray coating as claimed in claim 1, wherein the alkali soluble resin comprises a resin composed of a main chain having at least one of a polybenzoxazole structure and a polyimide structure, and at least one of a hydroxyl group, a carboxyl group, an ether bond and an ester bond each bonded to or contained in the main chain, a resin having a polybenzoxazole precursor structure, a resin having a polyimide precursor structure, or a resin having a polyamide acid ester structure.

3. The positive photosensitive resin composition for spray coating as claimed in claim 1, wherein the compound which generates the acid by the action of light comprises an ester compound of a phenolic compound and 1,2-naphthoquinone-2-diazide-5-sulfonic acid or 1,2-naphthoquinone-2-diazide-4-sulfonic acid.

4. The positive photosensitive resin composition for spray coating as claimed in claim 1, wherein the solvent has a boiling point of 210°C or lower and a vapor pressure of 25 kPa or lower at a temperature of 20°C.

5. A method for forming a cured film having a predetermined pattern on a substrate with the positive photosensitive resin composition for spray coating defined by claim 1, comprising:
spray coating the positive photosensitive resin composition onto the substrate to form a coating film on the substrate, baking the coating film, and then exposing and developing it in this order so that the coating film is patterned so as to have a pattern corresponding to the predetermined pattern; and
curing the patterned coating film to obtain the cured film having the predetermined pattern.

6. A cured film formed of a cured product of the positive photosensitive resin composition for spray coating defined by claim 1.

7. A semiconductor device, comprising:
a semiconductor substrate;
a semiconductor element provided on the semiconductor substrate; and
the cured film defined by claim 6 and provided on top of the semiconductor element.
